# EUROPEAN PATENT APPLICATION

(11) **EP 2 175 515 A1**
(43) Date of publication of application: **14.04.2010**
(21) Application number: 08790252.4
(22) Date of filing: 23.07.2008
(51) Int. Cl.: H01M 10/48, G01R 31/36, H01M 2/16, H01M 4/02

(54) **BATTERY INTERNAL SHORT-CIRCUIT DETECTING DEVICE AND METHOD, BATTERY PACK, AND ELECTRONIC DEVICE SYSTEM**

(30) Priority: 26.07.2007 JP 2007194814
(71) Applicant: Panasonic Corporation, Kadoma-shi Osaka 571-8501 (JP)
(72) Inventor: ASAKURA, Jun, Chuo-ku Osaka-shi Osaka 540-6207 (JP); NAKASHIMA, Takuya, Chuo-ku Osaka-shi Osaka 540-6207 (JP); NAKATSUJI, Toshiyuki, Chuo-ku Osaka-shi Osaka 540-6207 (JP); FUJIKAWA, Masato, Chuo-ku Osaka-shi Osaka 540-6207 (JP)
(74) Representative: Schwabe - Sandmair - Marx
(86) International application number: PCT/JP2008/001963
(87) International publication number: WO 2009/013898

(57) **Abstract**

An internal short-circuit detecting device for detecting an internal short circuit of a battery being subjected to constant current charge using a constant current amount (I) has: a voltage detection unit for detecting a terminal voltage of the battery; a terminal voltage acquisition unit for acquiring a terminal voltage (V1), as predetermined by the voltage detection unit, at a starting point of a first period (ΔW1) and a terminal voltage (V2) at an ending point; a voltage increase amount calculation unit for calculating an actual increase amount (ΔV3) of the terminal voltage of the first period (ΔW1) from the terminal voltages (V1 and V2); a voltage increase amount prediction unit for calculating a predicted increase amount (ΔV4) of the terminal voltage for the period when charging is performed using the current amount (I) for the first period (ΔW1); and an internal short-circuit determination unit for determining that the internal short circuit is generated when the actual increase amount (ΔV3) is equal to or lower than the sum of the predicted increase amount (ΔV4) and a predetermined coefficient (α).

## Description

### Technical Field

The present invention relates to a device a method, a battery pack and an electronic device system for detecting an internal short circuit of a nonaqueous electrolyte secondary battery, such as a nonaqueous electrolyte secondary battery that has, between its negative electrode and positive electrode, a heat-resistant layer composed of a porous protective film having a resin binder and an inorganic oxide filler, as well as a nonaqueous electrolyte olivine type iron lithium phosphate secondary battery with an electrode plate resistance of at least 4 Ω.cm².

### Background Art

Patent Document 1 and Patent Document 2, for example, describe a nonaqueous electrolyte secondary battery that has, between its negative electrode and positive electrode, a porous protective film with a resin binder and inorganic oxide filler. According to the structure of the nonaqueous electrolyte secondary battery with a porous protective film, even if active materials that fall off the electrodes or chips generated during a cutting process adhere to the surfaces of the electrodes at the time of manufacturing, an internal short circuit is prevented from occurring thereafter. However, due to this structure, a conventional method that is used in a conventionally-structured cell with no porous protective film has a problem of not being able to detect the occurrence of an internal short circuit even when the internal short circuit occurs.

In order to explain this problem, the conventional method that is used in the conventionally-structured cell with no porous protective film is described below first.

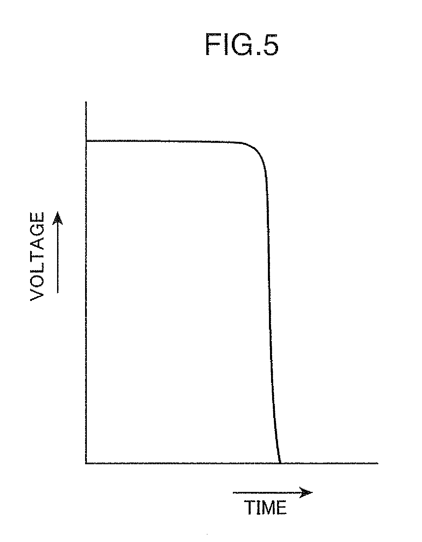

Specifically, when an internal short circuit occurs in the conventionally-structured cell with no porous protective film, the voltage of the cell drops rapidly, as shown in Fig. 5, and does not return thereafter. Therefore, the internal short circuit can be detected by either monitoring the voltage of the cell with an appropriate period or detecting a drastic temperature increase caused by a short circuit current.

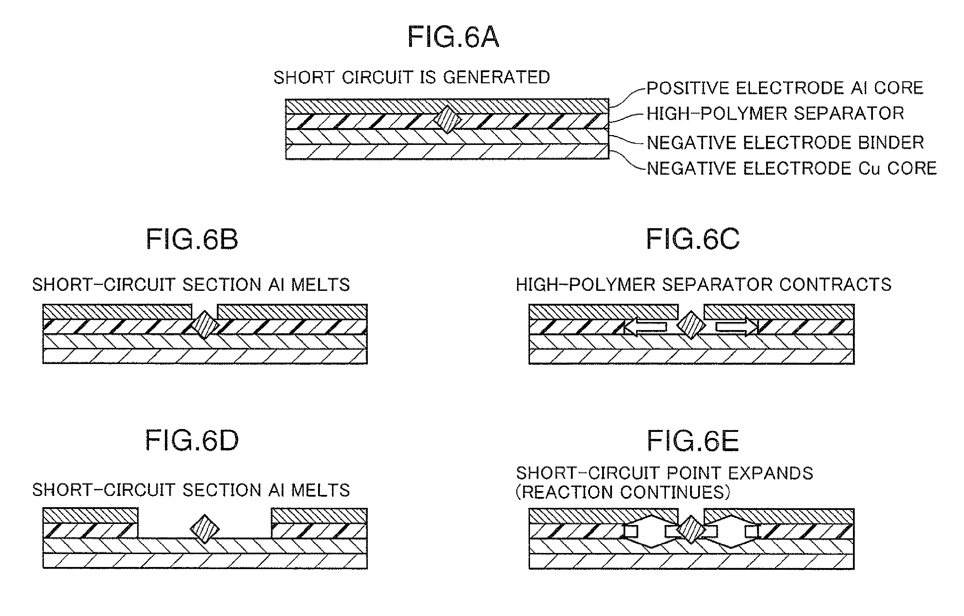

The following mechanisms explain the fact mentioned above. For example, when an internal short circuit shown in Fig. 6A is caused by a metallic foreign matter such as an electrode material or chip that falls off during the manufacturing process, the heat generated by the short circuit melts a positive-electrode aluminum core in a short circuit part, as shown in Fig. 6B. Subsequently, the heat generated from this melting melts and contracts a separator made of polyethylene or other high-polymer material, as shown in Fig. 6C, and a short circuit hole expands, as shown in Fig. 6D, whereby the short circuit area increases. Thereafter, the short circuit section melts, as shown in Fig. 6E, and the resultant heat repeats the expansion of the melting (short circuit hole) again as shown in Fig. 6C. In this manner, the voltage of the cell drops rapidly, and the drastic increase of the temperature of the cell is caused by the thermal runaway.

Patent Document 3, for example, discloses that an internal short circuit or the like can be detected at the time of non-operation, by storing the increase of the temperature caused by the internal short circuit or the like. Patent Document 3 also discloses that when a significant temperature increase is detected in relation to a significant voltage decrease, it is determined that an internal short circuit has occurred. Furthermore, Patent Document 4 discloses that an internal short circuit is detected from a voltage, pressure, temperature, sound, and the like. In addition, Patent Document 5 discloses that signals with plurality of frequencies are applied from an electrode to detect an internal short circuit.

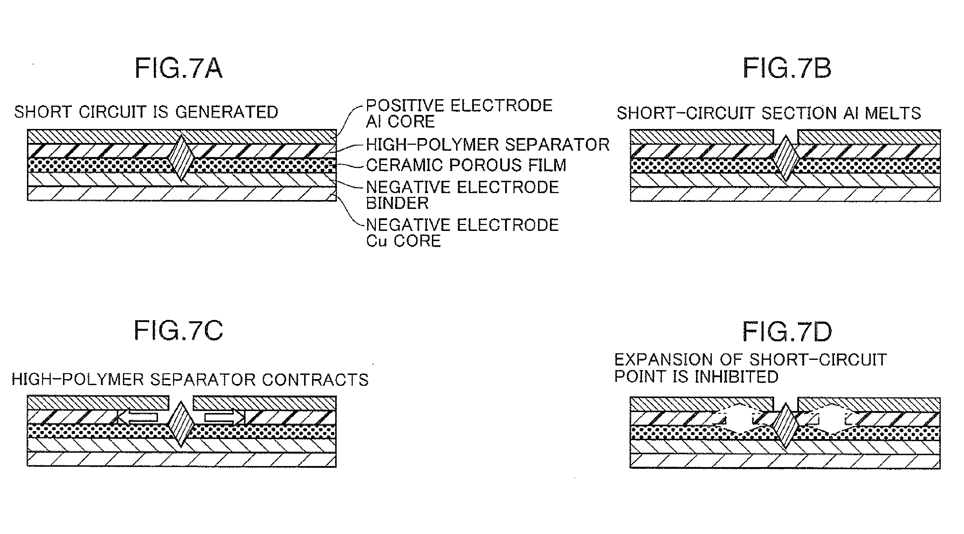

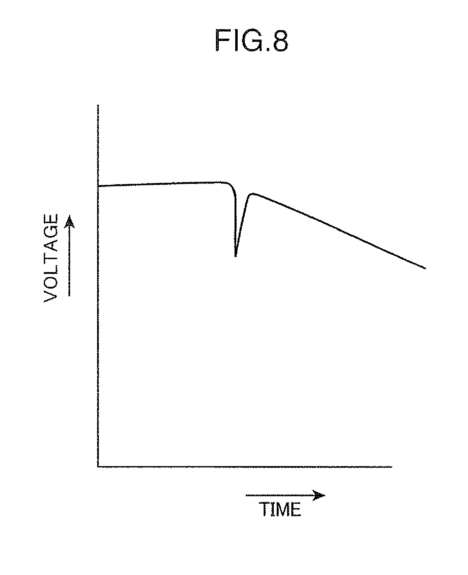

On the other hand, in the structure having the porous protective film as described in Patent Document 1 or Patent Document 2, when an internal short circuit occurs by the metallic foreign matter such as an electrode material or chip that falls off during the manufacturing process, as shown in Fig. 7A, the following takes place. In other words, even when the positive-electrode aluminum core of the short-circuit part melts as shown in Fig. 7B, the porous protective film prevents the positive-electrode aluminum core from coming into contact with a negative-electrode mixture. Therefore, as shown in Fig. 7B or Fig. 7C, the separator melts only in the vicinity of a region where the metallic foreign matter exists, whereby the expansion of the short circuit is inhibited. Thereafter, the voltage of the cell is nearly returned and can be used when there is a micro short circuit. Fig. 8 shows the changes of the voltage of the cell that occur upon generation of an internal short circuit in the structures described in Patent Document 1 and Patent Document 2. Therefore, it is difficult to detect an internal short circuit by using the methods described in Patent Documents 3 to 5.

Moreover, a secondary battery using olivine type iron lithium phosphate (LiFePO₄) as a positive-electrode material has a high thermal/chemical stability and is so inexpensive that it is expected to be used as an alternative to a secondary battery that uses lithium cobaltate (LiCoO₂). However, because the secondary battery using olivine type iron lithium phosphate (LiFePO₄) as the positive-electrode material has a low conductivity and the diffusion rate of lithium ion is extremely low, this secondary battery has the same problem of not being able to detect an internal short circuit by the methods in the above Patent Documents 3 to 5, as in the secondary batteries of Patent Document 1 and Patent Document 2 that are structured to have the porous protective film.
Patent Document 1: Japanese Patent Application No. 3371301
Patent Document 2: International Publication WO 05/098997
Patent Document 3: Japanese Patent Application Publication No. H8-83630
Patent Document 4: Japanese Patent Application Publication No. 2002-8631
Patent Document 5: Japanese Patent Application Publication No. 2003-317810

### Disclosure of the Invention

An object of the present invention is to provide a battery internal short-circuit detecting device and a method, a battery pack and an electronic device system capable of reliably detecting an internal short circuit in a battery whose voltage does not drop rapidly even when an internal short circuit is generated.

A battery internal short-circuit detecting device according to one aspect of the present invention is an internal short-circuit detecting device for detecting an internal short circuit of a battery being subjected to constant current charge using a constant current amount I, the internal short-circuit detecting device having: a voltage detection unit for detecting a terminal voltage of the battery; a terminal voltage acquisition unit for acquiring a terminal voltage V1, as predetermined by the voltage detection unit, at a starting point of a first period ΔW1 and a terminal voltage V2 at an ending point; a voltage increase amount calculation unit for calculating an actual increase amount ΔV3 of the terminal voltage of the first period ΔW1 from the terminal voltages V1 and V2; a voltage increase amount prediction unit for calculating a predicted increase amount ΔV4 of the terminal voltage for the period when charging is performed using the current amount I for the first period ΔW1; and an internal short-circuit determination unit for determining that an internal short circuit is generated, when the actual increase amount ΔV3 is equal to or lower than the sum of the predicted increase amount ΔV4 and a predetermined coefficient α.

According to the foregoing configuration, an internal short circuit can be detected reliably even in a battery whose voltage does not drop rapidly even when an internal short is generated, as will be described hereinafter.

In other words, when the terminal voltages of the battery do not increase proportionately to the amount of charge obtained in the constant current charge, it is speculated that an internal short circuit is generated by the above mentioned mechanisms and that a discharging current flows the short circuit section in the battery. Thus, the occurrence of the internal short circuit is determined by detecting the internal short circuit.

Specifically, the constant current charge is carried out for the predetermined first period ΔW1 using the constant current amount I, and the terminal voltage acquisition unit acquires the terminal voltage V1 of the starting point of the first period ΔW1 and the terminal voltage V2 of the ending point. Then, the actual increase amount ΔV3 of the terminal voltage of the first period ΔW1 is calculated from the terminal voltages V1 and V2 by the voltage increase amount calculation units, and the increase amount prediction unit calculates the predicted increase amount ΔV4 of the terminal voltage for the period when charging is performed using the current amount I for the first period ΔW1. Further, the internal short-circuit determination unit determines that the internal short circuit has occurred when the actual increase amount ΔV3 is equal to or lower than the sum of the predicted increase amount ΔV4 and the predetermined coefficient α.

As a result, an internal short circuit can be detected with a high degree of accuracy, even in a battery whose voltage does not drop drastically even when an internal short circuit is generated.

A battery internal short-circuit detecting device according to another aspect of the present invention is an internal short-circuit detecting device for detecting an internal short circuit of a battery being subjected to constant voltage charge using a constant voltage V, the internal-short circuit detecting device having: a current detection unit for detecting a charging current of the battery; a charging current acquisition unit for acquiring a charging current I1, as predetermined by the current detection unit, at a starting point of a second period ΔW2 and a charging current I2 at an ending point; a current decrease amount calculation unit for calculating an actual current decrease amount ΔI3 of the second period ΔW2 from the charging currents I1 and 12; a current decrease amount prediction unit for calculating a predicted decrease amount ΔI4 for the period when charging is performed using the voltage V for only the second period AW2; and an internal short-circuit determination unit for determining that an internal short circuit is generated, when the actual current decrease amount ΔI3 is equal to or lower than the sum of the predicted decrease amount ΔI4 and a predetermined coefficient α.

According to the foregoing configuration, the constant voltage charge is performed using the constant voltage V for the predetermined second period ΔW2 and the charging current acquisition unit acquires the charging current I1 of the starting point of the second period ΔW2 and the charging current I2 of the ending point. Then, the current decrease amount calculation unit calculates the actual current decrease amount ΔI3 for the second period ΔW2 from the charging currents I1 and I2, and the current decrease amount prediction unit calculates the predicted decrease amount ΔI4 for the period when charging is performed using the voltage V for the second period ΔW2. Further, the internal short-circuit determination unit determines that the internal short circuit has occurred when the actual current decrease amount ΔI3 is equal to or lower than the sum of the predicted decrease amount ΔI4 and the predetermined coefficient β.

As a result, an internal short circuit can be detected with a high degree of accuracy, even in a battery whose voltage does not drop drastically even when an interval short circuit is generated.

A battery internal short-circuit detecting method according to yet another aspect of the present invention is an internal-short circuit detecting method for detecting an internal short circuit in a battery being subjected to constant current charge using a constant current amount I, the internal short-circuit detecting method having: a step of detecting a terminal voltage of the battery; acquiring a terminal voltage V1, as predetermined by the voltage detection unit, at a starting point of a first period ΔW1 and a terminal voltage V2 at an ending point; a step of calculating an actual increase amount ΔV3 of the terminal voltage of the first period ΔW1 from the terminal voltages V1 and V2; a step of calculating a predicted increase amount ΔV4 of the terminal voltage during the period when charging is performed using the current amount I for the first period ΔW1; and an internal short-circuit determination step of determining that an internal short circuit is generated, when the actual increase amount ΔV3 is equal to or lower than the sum of the predicted increase amount ΔV4 and a coefficient α.

An internal short-circuit detecting method according to yet another aspect of the present invention is a battery internal short-circuit detecting method for detecting an internal short circuit in a battery being subjected to constant voltage charge using a constant voltage V, the internal short-circuit detecting method having: a step of detecting a charging current of the battery; a step of acquiring a charging current I1, as predetermined by the current detection unit, at a starting point of a second period ΔW2 and a charging current I2 at an ending point; a step of calculating an actual current decrease amount ΔI3 of the second period ΔW2 from the charging currents 11 and I2; a step of calculating a predicted decrease amount ΔI4 for the period when charging is performed using the voltage V for the second period ΔW2; and an internal short-circuit determination step of determining that an internal short circuit is generated, when the actual current decrease amount ΔI3 is equal to or lower than the sum of the predicted decrease amount ΔI4 and a predetermined coefficient β.

According to each of the foregoing internal short-circuit detecting methods of the present invention, the same effects as achieved from the configuration of each of the internal short-circuit detecting devices of the present invention described above can be accomplished.

A battery pack according to yet another aspect of the present invention has a battery and the battery internal short-circuit detecting device having each of the foregoing configurations.

An electronic device system according to yet another aspect of the present invention has a battery, a loading device supplied with power from the battery, and the battery internal short-circuit detecting device having each of the foregoing configurations.

According to the battery pack and the electronic device system of the present invention, the same effects as achieved from the configuration of each of the internal short-circuit detecting devices of the present invention described above can be accomplished.

The object, characteristics and advantages of the present invention will be more clearly understood through from the following detailed description and the accompanied drawings.

### Brief Description of the Drawings

[Fig. 1] Fig. 1 is a block diagram showing an electrical configuration of an electronic device system, which is an internal short-circuit detecting device of a nonaqueous electrolyte secondary battery according to an embodiment of the present invention.
[Fig. 2] Fig. 2 is a graph which explains a method of managing a charging voltage and current to illustrate an internal short-circuit determination operation according to an embodiment of the present invention.
[Fig. 3] Fig. 3 is a flowchart which illustrates in detail the internal short-circuit determination operation according to an embodiment of the present invention.
[Fig. 4] Fig. 4 is a graph which illustrates how the charging voltage and current change between a brand-new condition and a deteriorated condition.
[Fig. 5] Fig. 5 is a graph showing changes in voltage at the time of the occurrence of an internal short circuit in a conventionally-structured secondary battery cell.
[Fig. 6] Figs. 6A to 6E are schematic cross-sectional diagrams which illustrate a phenomenon of an internal short-circuit section in the conventionally-structured secondary battery cell.
[Fig. 7] Figs. 7A to 7D is a schematic cross-sectional diagram which illustrates a phenomenon of an internal short-circuit section in a nonaqueous electrolyte secondary battery that has, between its negative electrode and positive electrode, a heat-resistant layer composed of a porous protective film having a resin binder and an inorganic oxide filler.
[Fig. 8] Fig. 8 is a graph for showing changes in voltage at the time of the occurrence of an internal short circuit in the nonaqueous electrolyte secondary battery cell that has, between its negative electrode and positive electrode, a heat-resistant layer composed of a porous protective film having a resin binder and an inorganic oxide filler.

### Best Mode for Carrying Out the Invention

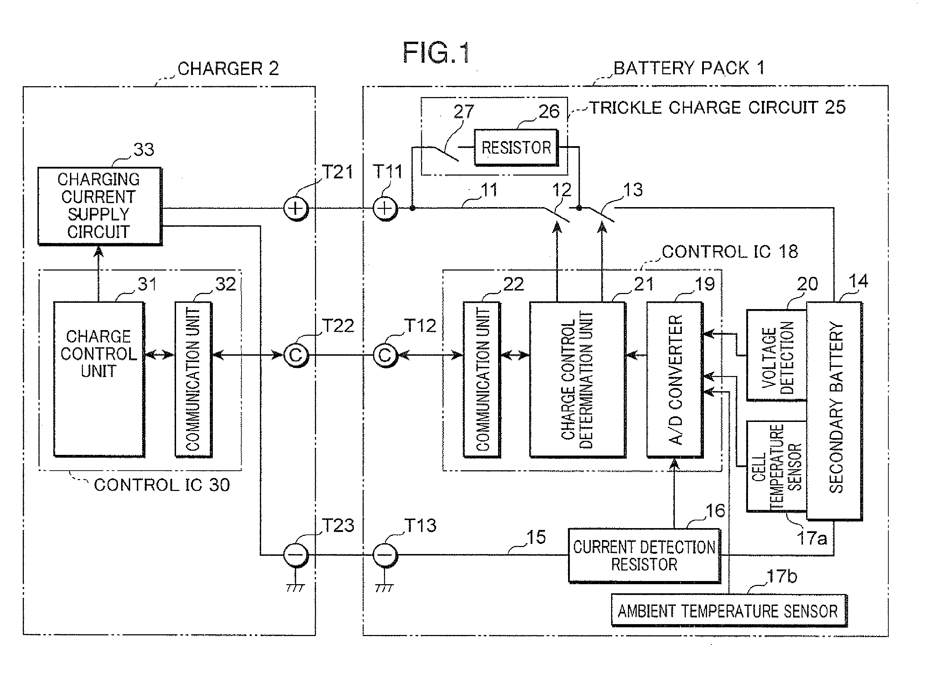

Fig. 1 is a block diagram showing an electrical configuration of a charging system, to which an internal short-circuit detecting method of a nonaqueous electrolyte secondary battery according to an embodiment of the present invention is applied. This charging system is configured by providing a battery pack 1 with a charger 2 for charging the battery pack 1, but a loading device, not shown, that is supplied with power from the battery pack 1 may be further included to configure an electronic device system.

The battery pack 1 and the charger 2 are interconnected with each other by DC high-side terminals T11, T21 for power supply, terminals T12, T22 for communication signals, and GND terminals T13, T23 for power supply and communication signals. The same terminals are provided when the loading device is provided.

In the battery pack 1, charging and discharging FETs 12, 13 of different conductive types are interposed in a charging/discharging path 11 on the DC high side that extends from the terminal T11s, and this charging/discharging path 11 is connected to a high-side terminal of a secondary battery (battery) 14. A low-side terminal of the secondary battery 14 is connected to the GND terminals T13 via a charging/discharging path 15, and a current detecting resistor 16 for converting a charging current and a discharging current into a voltage value is interposed in this charging/discharging path 15.

The secondary battery 14 is configured by connecting a plurality of cells in series or in parallel or by combining the serial and parallel connections thereof. The temperature of the cells is detected by a cell temperature sensor 17a and input to an analog/digital converter 19 within a control IC 18. The ambient temperature is detected by an ambient temperature sensor 17b and similarly input to the analog/digital converter 19 within the control IC 18. The voltage between terminals of each cell is read by a voltage detection circuit 20 and input to the analog/digital converter 19 within the control IC 18. Furthermore, a current value detected by the current detecting resistor 16 is also input to the analog/digital converter 19 within the control IC 18. The analog/digital converter 19 converts each input value into a digital value and outputs the digital value to a charge control determination unit 21.

The charge control determination unit 21 has a microcomputer, a peripheral circuit thereof, and the like. In response to each input value from the analog/digital converter 19, this charge control determination unit 21 calculates for the charger 2 a voltage value and current value of a charging current that are required to be output, and transmits the calculated voltage value and current value from a communication unit 22 to the charger 2 via the terminals T12, T22; T13, T23, Based on each input value from the analog/digital converter 19, the charge control determination unit 21 also detects an abnormality on the outside of the battery pack 1, such as a short circuit between the terminals T11, T13 or an abnormal current from the charger 2, and also detects an abnormality inside the battery pack 1, such as an abnormal increase in the temperature of the secondary battery 14 or the occurrence of an internal short circuit, which will be described hereinafter. Then, when these abnormalities are detected, the charge control determination unit 21 blocks the FETs 12, 13 or performs other protective operation. When charging/discharging is carried out normally, the charge control determination unit 21 turns the FETs 12, 13 ON to enable charging/discharging, but turns the FETs 12, 13 OFF when the abnormalities are detected, to disable the charging/discharging.

In the charger 2, the voltage value and current value of a charging current that are required to be output are received at a communication unit 32 of a control IC 30. A charge control unit 31 controls a charging current supply circuit 33 to supply a charging current based on the voltage value and current value received by the communication unit 32. The charging current supply circuit 33 configured by an AC-DC converter or DC-DC converter converts an input voltage into a voltage value and current value specified by the charge control unit 31, and supplies the voltage value and current value to the charging/discharging paths 11, 15 via the terminals T21, T11; T23, T13.

In the battery pack 1, the charging/discharging path 11 on the DC high side is provided with a trickle charge circuit 25 in parallel with the normal (fast) charging FET 12. This trickle charge circuit 25 is configured by a series circuit of a current-limiting resistor 26 and an FET 27. When performing auxiliary charging at the beginning of charging or around the time when the battery is fully charged, the charge control determination unit 21 turns the fast charging FET 12 OFF and the trickle charging FET 27 ON to carry out trickle charging, while leaving the discharging FET 13 ON. On the other hand, at the time of normal charging and discharging, the charge control determination unit 21 turns the FET 12 ON and the FET 27 OFF to carry out charging/discharging using a normal current, while leaving the FET 13 ON. For example, in the case of a lithium-ion battery, the charge control unit 21 determines whether to carry out the trickle charging at the beginning of charging, based on whether or not the voltage between terminals of each cell that is detected by the voltage detection circuit 20 is equal to or lower than 2.5 V. In this case, when the voltage between terminals of each cell that is detected by the voltage detection circuit 20 exceeds 2.5 V, the charge control determination 21 performs fast charging from the beginning without performing the trickle charging.

In the battery pack 1 configured above, the secondary battery 14 of the present embodiment is configured by a nonaqueous electrolyte secondary battery that has, between its negative electrode and positive electrode, a heat-resistant layer (porous protective film) as shown in Fig. 6, or a nonaqueous electrolyte olivine type iron lithium phosphate secondary battery with an electrode plate resistance of at least 4 Ω·cm². It should be noted that the charge control determination unit 21 functioning as determination means determines whether or not an internal short circuit is generated in the secondary battery 14 in the following manner, in response to the results of detection performed by the voltage detection circuit 20 functioning as voltage detection means and the current detecting resistor 16 functioning as current detection means.

Each of the functions of the charge control determination unit 21 is realized by the CPU or storage devices (ROM, RAM) of the microcomputer.

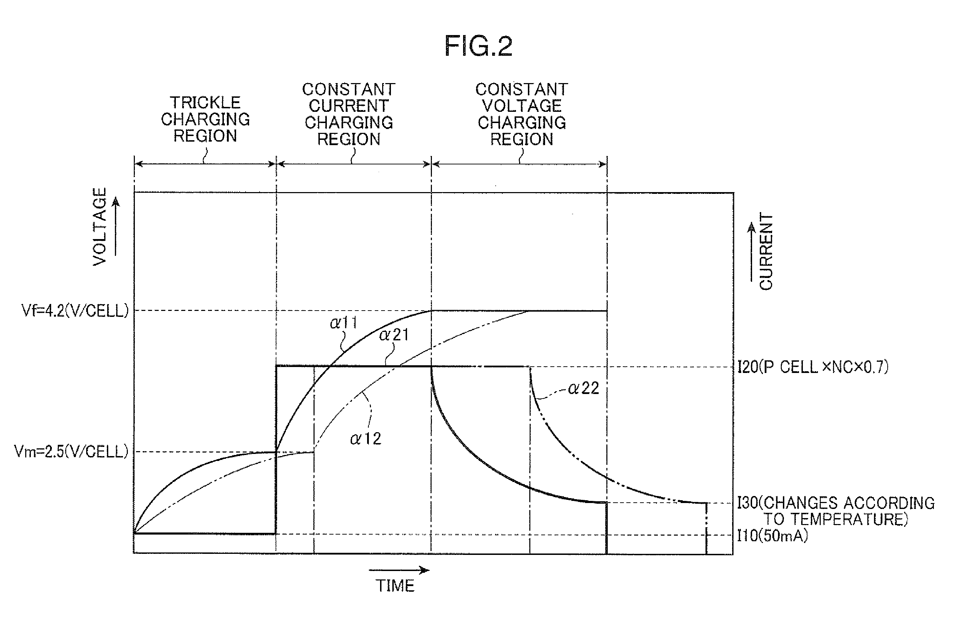

Fig. 2 is a graph which explains a method of managing a charging voltage and current to illustrate a determination operation performed by the charge control determination unit 21. Fig. 2 is a graph for a lithium-ion battery, wherein a referential mark α11 shows changes in a cell voltage of the secondary battery 14 in a normal state, and a referential mark α21 shows changes in a charging current supplied to the secondary battery 14 in the normal state.

For the voltage, first of all, the trickle charging is performed from the beginning of charging of the secondary battery 14 (trickle charging region), and a minute constant current 110 such as, a charging current of, for example, 50 mA is supplied. Charging by this trickle charging system is continued until the cell voltage of one or more cells reaches an end voltage Vm of the trickle charging, that is, 2.5 V.

When the cell voltage reaches the end voltage Vm, the charging system is switched to a constant current charging system (constant current charging region). The constant current (CC) charging is performed until the voltage between the terminals T11, T13 of the battery pack 1 becomes a predetermined end voltage Vf at which the terminal voltage per cell is 4.2 V (12.6 V in the case of a series of three cells, for example). During a period when this constant current charge is carried out, the end voltage Vf is added to a charging terminal and a predetermined constant current I20 is supplied. For example, when the constant current charging is performed at a nominal capacitance value NC and the current value at which residual capacity of the cells becomes zero in one hour is 1C (1It), the constant current 120 becomes a charging current obtained by multiplying the 70% of the constant current 120 by the number of parallel cells P.

When the voltage between the terminals T11, T13 becomes the end voltage Vf, the charging system is switched to a constant voltage charging system (constant voltage charging region), and constant voltage charging is continued until the charging current value is reduced to a predetermined current value 130. During the period when this constant voltage charging is carried out, the charging current value decreases such that the voltage between the terminals T11, T13 does not exceed the end voltage Vf, and when the charging current value is reduced to the predetermined current value 130, it is determined that the battery is fully charged and the supply of the charging current is stopped.

On the other hand, a referential mark α12 shows changes in the cell voltage of the secondary battery 14 that occur when the above mentioned internal short circuit is generated. A referential mark α22 shows changes in the charging current supplied to the secondary battery 14 when the internal short circuit is generated. In this case, although the cell voltage of the secondary battery 14 increases, the internal short circuit is generated due to the mechanisms shown in Figs. 7A to 7D. Hence, even when the same trickle charging and the charging with the constant current (CC) charging system are carried out, the rate of increase of the cell voltage is slower than when an internal short circuit is not generated, and consequently the rate of switching of the charging current from 110 to 120 and then to 130 and the charging current slows down as well, as indicated by double-dashed lines in Fig. 2. Therefore, in this embodiment, at the time of the constant current (CC) charging, the charge control determination unit 21 determines that the above mentioned internal short circuit has occurred, based on the actual increase amount ΔV3 of the cell voltage V detected by the voltage detection circuit 20, for a predetermined first period ΔW1 during which the charging current is supplied. At the time of constant voltage (CV) charging, the charge control determination unit 21 determines that the above mentioned internal has occurred, based on the actual decrease amount ΔI3 of the charging current detected by the current detection resistor 16, for a predetermined second period ΔW2 during which charging is carried out with the constant voltage V.

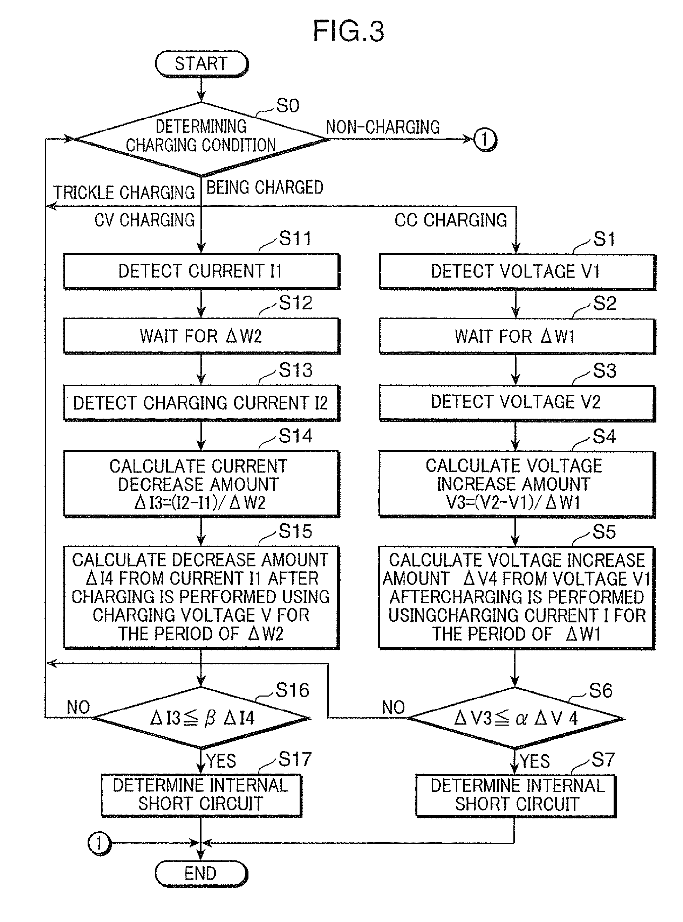

Fig. 3 is a flowchart which illustrates in detail the determination operation performed by the charge control determination unit 21. The charge control determination unit 21 determines a charging condition of the secondary battery 14 in step S0. When the secondary battery 14 is in a non-charging condition as a result of the determination in step S0 the process is ended. When, on the other hand, it is determined in step S0 that the secondary battery 14 is being charged, as long as the charging is performed by the trickle charging system (the trickle charging region in Fig. 2), the secondary battery 14 waits in step S1 until the charging is switched to the charging performed by the constant current charging system (the constant current charging region in Fig. 2).

When the charging system for the secondary battery 14 is switched to the constant current charging system, in step S1 the charge control determination unit 21 loads the result of the detection performed by the voltage detection circuit 20 via the analog/digital converter 19, and stores this detection result in a memory as the terminal voltage V1 of the starting point of the first period ΔW1 in which the charging is performed with a constant current amount I. Next, after waiting for the first period ΔW1 in step S2, the result of the detection performed by the voltage detection circuit 20 is loaded again in step S3, and this detection result is stored in the memory as the terminal voltage V2 of the ending point of the first period ΔW1. In step S4, the actual increase amount ΔV3 of the terminal voltage in the first period ΔW1 is calculated. In step S5, on the other hand, a predicted increase amount ΔV4 of the terminal voltage during this period for the case of charging with the current amount I during the first period ΔW1 is calculated from a look-up table or the like that is stored in the memory in advance. Then, in step S6, when the actual increase amount ΔV3 of the terminal voltage is equal to or lower than the sum of the predicted increase amount ΔV4 of the terminal voltage and a predetermined coefficient α, the charge control determination unit 21 determines in step S7 that an internal short circuit has occurred. Then, the charge control determination unit 21 blocks the FETs 12, 13 or performs other protective operation. The look-up table for the predicted increase amount ΔV4 is shown in Table 1, for example.

**[Table 1]**

| Time (minutes) | Voltage (V) |
|---|---|
| 0 | 3.50 |
| 10 | 3.75 |
| 20 | 3.85 |
| 30 | 3.90 |
| 40 | 3.94 |
| 50 | 3.98 |
| 60 | 4.03 |
| 70 | 4.07 |
| 80 | 4.14 |
| 90 | 4.20 |

This Table 1 shows the changes in the cell voltage of the secondary battery 14 for the case where the charging is performed with the constant current I, from a low voltage of 3.5 V to a high voltage of 4.2 V at which the constant voltage region is reached. Therefore, when, for example, V1 is 3.75 V and the first period ΔW1 is one minute, the charge control determination unit 21 can calculate the predicted increase amount ΔV4 as 0.01 V based on linear approximation, from a difference 0.1 V between 3.75 V and a voltage of 3.85 V obtained 10 minutes later. Although this look-up table shows the relationship between the voltage and time when the constant current charging is carried out, the predicted increase amount ΔV4 can be calculated by using a look-up table that shows the relationship between the remaining charge amount (SOC) and the voltage.

On the other hand, when the constant voltage charging region is reached, in step S11 the charge control determination unit 21 loads the result of the detection performed by the current detection resistor 16 via the analog/digital converter 19, and stores this detection result in the memory as the charging current I1 of the starting point of the second period ΔW2 in which the charging is carried out with the constant voltage V. After waiting for the predetermined second period ΔW2 in step S12, the detection result of the current detection resistor 16 is loaded again in step S 13, and this detection result is stored in the memory as the charging current I2 of the ending point of the second period ΔW2. In step S14, the actual current decrease amount ΔI3 of the second period ΔW2 is calculated. In step S15, on the other hand, the predicted decrease amount ΔI4 during this period for the case of performing the charging with the voltage V (= Vf of 4.2 V) for the second period ΔW2 is calculated from a look-up table or the like that is stored in the memory in advance. In step S16, when the actual current decrease amount ΔI3 is equal to or lower than the sum of the predicted decrease amount ΔI4 of the current and a predetermined coefficient β, the charge control determination unit 21 determines in step S 17 that an internal short circuit has occurred. The charge control determination unit 21 then blocks the FETs 12, 13 or performs other protective operation. The look-up table for the predicted decrease amount ΔI4 is shown by Table 2 and Table 3, for example.

**[Table 2]**

| Time (minutes) | Current (mA) |
|---|---|
| 5 | 1070 |
| 10 | 757 |
| 15 | 525 |
| 20 | 369 |
| 25 | 264 |
| 30 | 193 |
| 35 | 142 |
| 40 | 105 |
| 45 | 72 |

**[Table 3]**

| Time (minutes) | Current (mA) |
|---|---|
| 5 | 1070 |
| 10 | 842 |
| 15 | 603 |
| 20 | 454 |
| 25 | 363 |
| 30 | 293 |
| 35 | 234 |
| 40 | 183 |
| 45 | 142 |
| 50 | 105 |
| 55 | 72 |
| 60 | 71 |
| 65 | 70 |

These Table 2 and Table 3 show the changes in the charging current of the secondary battery 14 for the case where the charging is carried out with a constant voltage of 4.2 V from the point of time when the constant current charging system (a low current region in Fig. 2) is switched to the constant voltage charging system (a constant voltage region in Fig. 2). However, Table 2 shows a brand-new condition, while Table 3 shows the condition of the battery that is deteriorated due to cyclical use thereof. The look-up tables of these Table 2 and Table 3 may not necessarily created by all of the parameters, and some parameters may be obtained by performing the above mentioned auxiliary calculation. In addition, although these look-up tables show the relationship between the current and time of the constant voltage charging, the predicted decrease amount ΔI4 can be calculated by using a look-up table showing the relationship between the remaining charge amount (SOC) and the charging current.

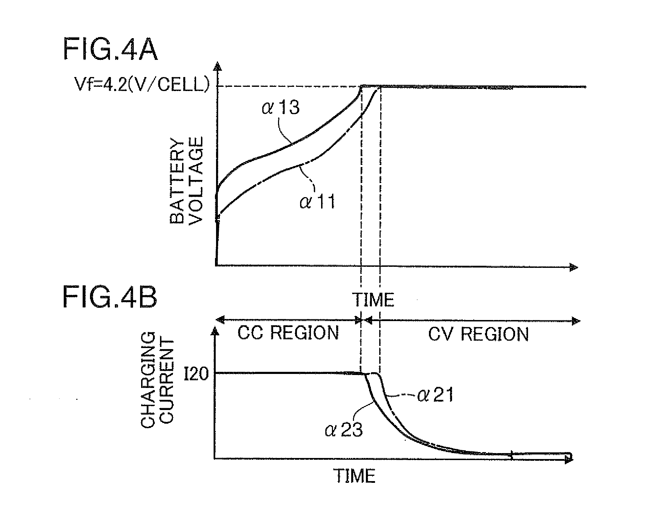

Fig. 4 is shows changes in the voltage used upon the charging of the brand-new battery and the deteriorated battery. In Fig. 4, (a) shows changes in the voltage, and (b) shows changes in the current. The referential marks α11 and α21 shows the changes in the voltage and current of the battery in the brand-new condition, the changes corresponding to Fig. 2, and referential marks α13 and α23 shows changes in the voltage and current of the battery in the deteriorated condition. The changes in the current shown by the referential marks α21, α23 correspond to Table 2 and Table 3 above.

As deterioration progresses, the capacity of the secondary battery 14 decreases and the voltage rises rapidly at the time of the constant current charging. However, no significant change occurs in the predicted increase amount ΔV4 of the terminal voltage, and the look-up table shown in Table 1 can be used. In the constant voltage (CV) charging region, on the other hand, because an internal resistance value increases, the predicted decrease amount ΔI4 tends to decrease. Erroneous detection can be prevented by switching between Table 2 and Table 3. Note that more various types of look-up tables types in accordance with not only the number of samplings at time intervals but also the degree of deterioration may be used.

In the configuration above, when a nonaqueous electrolyte secondary battery that has, between its negative electrode and positive electrode, a heat-resistant layer composed of a porous protective film having a resin binder and an inorganic oxide filler, or a nonaqueous electrolyte olivine type iron lithium phosphate secondary battery with an electrode plate resistance of at least 4 Ω·cm² is used as the secondary battery 14, the cell voltage does not decrease drastically as in a normal secondary battery, even when an internal short circuit occurs. Therefore, in the conventional method, it is difficult to detect an internal short circuit from sampling values of the data, such as the voltage, current and temperature of the secondary battery.

However, in the battery internal short-circuit detecting device and method according to the present embodiment, as described above, even when a charging current flows, it is determined that an internal short circuit has occurred, when the cell voltage does not increase proportionally to temporal change at the time of the constant current (CC) charging or when the rate of decrease (drop) of the charging current is slow at the time of the constant voltage (CV) charging. Therefore, even in a battery whose voltage does not drop drastically even when an internal short circuit occurs, the internal short circuit can be detected reliably.

Note that the battery internal short-circuit detecting device or method according to the present embodiment can be preferably used in, but not limited to, the nonaqueous electrolyte secondary battery that has a heat-resistant layer between its negative electrode and the positive electrode and the nonaqueous electrolyte secondary battery that has an electrode plate resistance of at least 4 Ω·cm². In other words, the battery internal short-circuit detecting device or method according to the present embodiment can be preferably used to a battery whose voltage does not drop drastically even when an internal short circuit occurs.

Moreover, although the present embodiment shows an aspect where the battery internal short-circuit detecting device is embedded in the battery pack, the present embodiment is not limited thereto, and the internal short-circuit detecting device may be incorporated in the loading device.

The battery internal short-circuit detecting device according to one aspect of the present invention is an internal short-circuit detecting device for detecting an internal short circuit of a battery being subjected to constant current charge using a constant current amount I, the internal short-circuit detecting device having: a voltage detection unit for detecting a terminal voltage of the battery; a terminal voltage acquisition unit for acquiring a terminal voltage V1, as predetermined by the voltage detection unit, at a starting point of a first period ΔW1 and a terminal voltage V2 at an ending point; a voltage increase amount calculation unit for calculating an actual increase amount ΔV3 of the terminal voltage of the first period ΔW1 from the terminal voltages V1 and V2; a voltage increase amount prediction unit for calculating a predicted increase amount ΔV4 of the terminal voltage for the period when charging is performed using the current amount I for the first period ΔW1; and an internal short-circuit determination unit for determining that an internal short circuit is generated, when the actual increase amount ΔV3 is equal to or lower than the sum of the predicted increase amount ΔV4 and a predetermined coefficient α.

According to the foregoing configuration, an internal short circuit can be detected reliably even in a battery whose voltage does not drop rapidly even when an internal short is generated, as will be described hereinafter.

In other words, when the terminal voltages of the battery do not increase proportionately to the amount of charge obtained in the constant current charge, it is speculated that an internal short circuit is generated by the above mentioned mechanisms and that a discharging current flows the short circuit section in the battery. Thus, the occurrence of the internal short circuit is determined by detecting the internal short circuit.

Specifically, the constant current charge is carried out for the predetermined first period ΔW1 using the constant current amount I, and the terminal voltage acquisition unit acquires the terminal voltage V1 of the starting point of the first period ΔW1 and the terminal voltage V2 of the ending point. Then, the actual increase amount ΔV3 of the terminal voltage of the first period ΔW1 is calculated from the terminal voltages V1 and V2 by the voltage increase amount calculation units, and the increase amount prediction unit calculates the predicted increase amount ΔV4 of the terminal voltage for the period when charging is performed using the current amount I for the first period ΔW1. Further, the internal short-circuit determination unit determines that the internal short circuit has occurred when the actual increase amount ΔV3 is equal to or lower than the sum of the predicted increase amount ΔV4 and the predetermined coefficient α.

As a result, an internal short circuit can be detected with a high degree of accuracy, even in a battery whose voltage does not drop drastically even when an internal short circuit is generated.

A battery internal short-circuit detecting device according to another aspect of the present invention is an internal short-circuit detecting device for detecting an internal short circuit of a battery being subjected to constant voltage charge using a constant voltage V, the internal-short circuit detecting device having: a current detection unit for detecting a charging current of the battery; a charging current acquisition unit for acquiring a charging current I1, as predetermined by the current detection unit, at a starting point of a second period ΔW2 and a charging current 12 at an ending point; a current decrease amount calculation unit for calculating an actual current decrease amount ΔI3 of the second period ΔW2 from the charging currents I1I and 12; a current decrease amount prediction unit for calculating a predicted decrease amount ΔI4 for the period when charging is performed using the voltage V for the second period ΔW2; and an internal short-circuit determination unit for determining that an internal short circuit is generated, when the actual current decrease amount ΔI3 is equal to or lower than the sum of the predicted decrease amount ΔI4 and a predetermined coefficient α.

According to the foregoing configuration, the constant voltage charge is performed using the constant voltage V for the predetermined second period ΔW2, and the charging current acquisition unit acquires the charging current I1 of the starting point of the second period ΔW2 and the charging current I2 of the ending point. Then, the current decrease amount calculation unit calculates the actual current decrease amount ΔI3 for the second period ΔW2 from the charging currents I1 and I2, and the current decrease amount prediction unit calculates the predicted decrease amount ΔI4 for the period when charging is performed using the voltage V for the second period ΔW2. Further, the internal short-circuit determination unit determines that the internal short circuit has occurred when the actual current decrease amount ΔI3 is equal to or lower than the sum of the predicted decrease amount ΔI4 and the predetermined coefficient β.

As a result, an internal short circuit can be detected with a high degree of accuracy, even in a battery whose voltage does not drop drastically even when an internal short circuit is generated.

In the configuration above, for example, the nonaqueous electrolyte secondary battery having a heat-resistant layer between its negative electrode and positive electrode, or the nonaqueous electrolyte secondary battery having an electrode plate resistance of at least 4 Ω·cm² can be used as the battery.

A battery internal short-circuit detecting method according to yet another aspect of the present invention is an internal-short circuit detecting method for detecting an internal short circuit in a battery being subjected to constant current charge using a constant current amount I, the internal short-circuit detecting method having the steps of: detecting a terminal voltage of the battery; acquiring a terminal voltage V1, as predetermined by the voltage detection unit, at a starting point of a first period ΔW1 and a terminal voltage V2 at an ending point; calculating an actual increase amount ΔV3 of the terminal voltage of the first period ΔW1 from the terminal voltages V1 and V2; calculating a predicted increase amount ΔV4 of the terminal voltage during the period when charging is performed using the current amount I for the first period ΔW1; and determining that an internal short circuit is generated, when the actual increase amount ΔV3 is equal to or lower than the sum of the predicted increase amount ΔV4 and a coefficient α.

An internal short-circuit detecting method according to yet another aspect of the present invention is a battery internal short-circuit detecting method for detecting an internal short circuit in a battery being subjected to constant voltage charge using a constant voltage V, the internal short-circuit detecting method having the steps of: detecting a charging current of the battery; acquiring a charging current I1, as predetermined by the current detection unit, at a starting point of a second period ΔW2 and a charging current I2 at an ending point; calculating an actual current decrease amount ΔI3 of the second period ΔW2 from the charging currents I1 and I2; calculating a predicted decrease amount ΔI4 for the period when charging is performed using the voltage V for the second period ΔW2; and determining that an internal short circuit is generated, when the actual current decrease amount ΔI3 is equal to or lower than the sum of the predicted decrease amount ΔI4 and a predetermined coefficient β.

In the internal short-circuit detecting method above, for example, the nonaqueous electrolyte secondary battery having a heat-resistant layer between its negative electrode and positive electrode, or the nonaqueous electrolyte secondary battery having an electrode plate resistance of at least 4 Ω·cm² can be used as the battery.

According to each of the foregoing internal short-circuit detecting methods of the present invention, the same effects as achieved from the configuration of each of the internal short-circuit detecting devices of the present invention described above can be accomplished.

A battery pack according to yet another aspect of the present invention has a battery and the battery internal short-circuit detecting device having each of the foregoing configurations.

An electronic device system according to yet another aspect of the present invention has a battery, a loading device supplied with power from the battery, and the battery internal short-circuit detecting device having each of the foregoing configurations.

According to the battery pack and the electronic device system of the present invention, the same effects as achieved from the configuration of each of the internal short-circuit detecting devices of the present invention described above can be accomplished.

As mentioned above, the present invention can provide a battery internal short-circuit detecting device, a method, a battery pack and an electronic device system capable of reliably detecting an internal short circuit in a battery whose voltage does not drop rapidly even when an internal short circuit is generated.

### Industrial Applicability

The present invention can be utilized in a charging system that is used as electronic devices such as a portable personal computer, a digital camera, an uninterruptible power system and a cellular phone, as well as in a battery-mounted device such as an electric vehicle and a hybrid car. The present invention can also be utilized preferably in a battery pack used as the power source of such battery-mounted devices, and in a charging device for charging such a battery pack.

## Claims

1. An internal short-circuit detecting device for detecting an internal short circuit of a battery being subjected to constant current charge using a constant current amount I,
the internal short-circuit detecting device comprising:
a voltage detection unit for detecting a terminal voltage of the battery;
a terminal voltage acquisition unit for acquiring a terminal voltage V1, as predetermined by the voltage detection unit, at a starting point of a first period ΔW1 and a terminal voltage V2 at an ending point;
a voltage increase amount calculation unit for calculating an actual increase amount ΔV3 of the terminal voltage of the first period ΔW1 from the terminal voltages V1 and V2;
a voltage increase amount prediction unit for calculating a predicted increase amount ΔV4 of the terminal voltage for the period when charging is performed using the current amount I for the first period ΔW1; and
an internal short-circuit determination unit for determining that an internal short circuit is generated, when the actual increase amount ΔV3 is equal to or lower than the sum of the predicted increase amount ΔV4 and a predetermined coefficient α.

2. An internal short-circuit detecting device for detecting an internal short circuit of a battery being subjected to constant voltage charge using a constant voltage V,
the internal-short circuit detecting device comprising:
a current detection unit for detecting a charging current of the battery;
a charging current acquisition unit for acquiring a charging current I1, as predetermined by the current detection unit, at a starting point of a second period ΔW2 and a charging current I2 at an ending point;
a current decrease amount calculation unit for calculating an actual current decrease amount ΔI3 of the second period ΔW2 from the charging currents I1 and I2;
a current decrease amount prediction unit for calculating a predicted decrease amount ΔI4 for the period when charging is performed using the voltage V for only the second period ΔW2; and
an internal short-circuit determination unit for determining that an internal short circuit is generated, when the actual current decrease amount ΔI3 is equal to or lower than the sum of the predicted decrease amount ΔI4 and a predetermined coefficient β.

3. The internal short-circuit detecting device according to claim 1 or 2, wherein the battery is a nonaqueous electrolyte secondary battery that has a heat-resistant layer between a negative electrode and a positive electrode thereof, or a nonaqueous electrolyte secondary battery with an electrode plate resistance of at least 4 Ω·cm².

4. An internal-short circuit detecting method for detecting an internal short circuit of a battery being subjected to constant current charge using a constant current amount I,
the internal short-circuit detecting method comprising:
a step of detecting a terminal voltage of the battery;
a step of acquiring a terminal voltage V1, as predetermined by the voltage detection unit, at a starting point of a first period ΔW1 and a terminal voltage V2 at an ending point;
a step of calculating an actual increase amount ΔV3 of the terminal voltage of the first period ΔW1 from the terminal voltages V1 and V2;
a step of calculating an predicted increase amount ΔV4 of the terminal voltage during the period when charging is performed using the current amount for the first period ΔW1; and
an internal short-circuit determination step of determining that an internal short circuit is generated, when the actual increase amount ΔV3 is equal to or lower than the sum of the predicted increase amount ΔV4 and a coefficient α.

5. A battery internal short-circuit detecting method for detecting an internal short circuit of a battery being subjected to constant voltage charge using a constant voltage V,
the internal short-circuit detecting method comprising:
a step of detecting a charging current of the battery;
a step of acquiring a charging current I1, as predetermined by the current detection unit, at a starting point of a second period ΔW2 and a charging current 12 at an ending point;
a step of calculating an actual current decrease amount ΔI3 of the second period ΔW2 from the charging currents I1 and 12;
a step of calculating a predicted decrease amount ΔI4 for the period when charging is performed using the voltage V only for the second period ΔW2; and
an internal short-circuit determination step of determining that an internal short circuit is generated, when the actual current decrease amount ΔI3 is equal to or lower than the sum of the predicted decrease amount ΔI4 and a predetermined coefficient β.

6. The internal short-circuit detecting method according to claim 4 or 5, wherein the battery is a nonaqueous electrolyte secondary battery that has a heat-resistant layer between a negative electrode and a positive electrode thereof, or a nonaqueous electrolyte secondary battery with an electrode plate resistance of at least 4 Ω·cm².

7. A battery pack, comprising:
a battery; and
the internal short-circuit detecting device according to any one of claims 1 to 3.

8. An electronic device system, comprising:
a battery;
a loading device supplied with power from the battery; and
the internal short-circuit detecting device according to any one of claims I to 3.
